# EUROPEAN PATENT APPLICATION

(11) **EP 4 742 441 A1**
(43) Date of publication of application: **13.05.2026**
(21) Application number: 24849430.4
(22) Date of filing: 17.07.2024
(51) Int. Cl.: H01Q 1/24, H01Q 1/48, G06F 1/16, H05K 1/18

(54) **ELECTRONIC DEVICE COMPRISING ANTENNA**

(30) Priority: 31.07.2023 KR 20230100084; 06.10.2023 KR 20230133569
(71) Applicant: Samsung Electronics Co., Ltd., Suwon-si, Gyeonggi-do 16677 (KR)
(72) Inventor: KIM, Un, Suwon-si Gyeonggi-do 16677 (KR); KIM, Jongsuk, Suwon-si Gyeonggi-do 16677 (KR); SHIN, Yongjoo, Suwon-si Gyeonggi-do 16677 (KR); JEONG, Myunghun, Suwon-si Gyeonggi-do 16677 (KR); CHOE, Jaewon, Suwon-si Gyeonggi-do 16677 (KR); KIM, Gyusub, Suwon-si Gyeonggi-do 16677 (KR)
(74) Representative: Gulde & Partner
(86) International application number: PCT/KR2024/010310
(87) International publication number: WO 2025/028861

(57) **Abstract**

An electronic device comprising an antenna is provided. The electronic device comprises: an outer housing comprising the side surface of the electronic device; a display device of which at least a portion is exposed through a first surface of the outer housing, the display device including a plurality of layers, which includes a flexible printed circuit board (FPCB) layer, the FPCB layer including a first portion and a second portion divided from the first portion, and the second portion including a conductive member formed in a partial area of an edge of the FPCB layer; a printed circuit board disposed between a second surface of the outer housing and the display device; a feeding line for connecting a communication circuit on the printed circuit board to the outer housing to feed power to the outer housing; and a ground line for connecting the conductive member to the printed circuit board.

## Description

### [Technical Field]

The disclosure relates to an electronic device including an antenna.

### [Background Art]

Electronic devices, such as smartphones, tablet PCs, or wearable devices, may perform various functions. An electronic device may be provided with a communication function, and may perform various functions such as voice calling, message checking, or wireless payment. An electronic device may be manufactured to be small in size and lightweight so as to be easily worn on a part of a body such as a wrist, and may have a limited mounting space. The electronic device may accommodate various components such as devices, modules, or antennas within the limited mounting space. In addition, with the advancement of communication technology, the types of frequencies required even for wearable devices, including smart watches, have increased, and accordingly, the number of antennas mounted in the electronic devices and the bandwidths of frequencies required for each antenna have been increasing.

### [DISCLOSURE OF INVENTION]

### [Solution to Problem]

An embodiment of the disclosure may provide an electronic device that includes an outer housing 220 including a first surface oriented in a first direction, a second surface oriented in a second direction opposite to the first direction, and a side surface surrounding a space between the first surface and the second surface, and a display device 210 which is exposed, at least in part, through the first surface of the outer housing. The display device may include a plurality of layers including a flexible printed circuit board (FPCB) layer 215, the FPCB layer may include a first portion 40a and a second portion 40b separated from the first portion, and the second portion 40b may include a conductive member formed in a portion of an edge of the FPCB layer. The electronic device may further include a printed circuit board 260 disposed between the second surface of the outer housing and the display device, a feeding line 44 connecting a communication circuit on the printed circuit board to the outer housing so as to feed power to the outer housing, and a grounding line 41 connecting the conductive member to the printed circuit board. In addition, the grounding line may be included in a connector 43 that connects the printed circuit board to the display device.

In addition, an embodiment of the disclosure may provide an electronic device that includes an outer housing 220 including a conductive structure formed in a region including a side surface of the electronic device, a display device 210 which is exposed, at least in part, through a first surface of the outer housing. The display device may include a flexible printed circuit board (FPCB) layer 215, the FPCB layer may include a first portion 40a and a second portion 40b separated from the first portion, and the second portion may be formed in a portion of an edge of the FPCB layer and may include a conductive member 40. The electronic device may further include a printed circuit board 260 disposed between a second surface of the outer housing opposite to the first surface and the display device, and a grounding line 41 connecting the conductive member to the printed circuit board. In addition, the grounding line may be included in a connector 43 that connects the printed circuit board to the display device.

### [BRIEF DESCRIPTION OF DRAWINGS]

FIG. 1 is a block diagram of an electronic device according to various embodiments in a network environment (100).
FIG. 2 is a perspective view of an electronic device according to an embodiment.
FIG. 3 is an exploded view of the electronic device according to an embodiment.
FIG. 4 is a cross-sectional view of an electronic device according to an embodiment of the disclosure.
FIG. 5 is a cross-sectional view of a display device according to an embodiment.
FIG. 6 is a view illustrating divided first and second portions of an FPCB according to an embodiment.
FIG. 7 is a view illustrating an example in which an electrical length of an antenna radiator including at least a portion of an outer housing and a display device is adjusted as the outer housing is fed with power, according to an embodiment.
FIG. 8 is a view illustrating a length and a width of a conductive member formed in a second portion of an FPCB according to an embodiment.
FIG. 9 is a view illustrating radiation performance of an antenna radiator according to a length of a conductive member formed in the second portion of an FPCB according to an embodiment.
FIG. 10 is a view illustrating radiation performance of an antenna radiator according to a width of a conductive member formed in the second portion of an FPCB according to an embodiment.
FIG. 11 is a view illustrating an example in which a conductive member formed in a second portion of an FPCB and a matching circuit of a printed circuit board are connected by a switch according to an embodiment.
FIG. 12 is a view illustrating wire connections between a display device and a printed circuit board according to an embodiment.
FIG. 13 is a view illustrating wire connections among a conductive member disposed under a display device, the display device, and a printed circuit board according to an embodiment.
FIG. 14 is a view illustrating wire connections among a conductive member disposed under a display device, the display device, and a printed circuit board according to an embodiment.
FIG. 15 is a view illustrating examples of arrangement positions of a feeding point, a grounding point, and a switch of an electronic device according to an embodiment.
FIG. 16 is a view illustrating an example in which a conductive member formed in a second portion of an FPCB is fed with power, according to an embodiment.
FIG. 17 is a view illustrating performance of an antenna radiator in a case where power is fed to the conductive member formed in the second portion of the FPCB according to an embodiment.
FIG. 18 is a block diagram (1800) of an electronic device (101) configured to support legacy network communication and 5G network communication according to various embodiments.

### [MODE FOR THE INVENTION]

Hereinafter, embodiments of the disclosure will be described in detail with reference to the accompanying drawings so that those skilled in the art to which the disclosure pertains may easily implement the disclosure. However, the disclosure may be implemented in various different forms and is not limited to embodiments set forth herein. To clearly describe the disclosure, parts irrelevant to the description are omitted from the drawings, and similar or like parts are provided with similar or like reference signs.

The terms as used herein are expressed using currently used general terms in consideration of the functions mentioned in the disclosure,and may mean various different terms according to intentions of technicians engaged in the art, customs, or emergence of new technologies, and the like. Therefore, the terms as used herein should not be interpreted only by the nominal names the terms, but should be interpreted based on the meanings of the terms and the contents throughout the disclosure.

Such terms as "a first" and "a second" may be used to describe various elements, but the elements should not be limited by the terms. Theses terms are used only for the purpose of distinguishing one element from any other element.

Throughout the specification, when a certain part is described as being "connected" to another part, this includes not only the case where they are "directly connected" but also the case where they are "electrically connected" with another component interposed therebetween. Furthermore, when a part is referred to as "including" an element, it does not exclude the presence of other elements and may further include other elements.

As used herein, such phrases as "in an embodiment" appearing in various places of the disclosure do not necessarily refer to the same embodiment.

An embodiment of the disclosure may be represented by functional block elements and various processing steps. Some or all of the functional blocks may be implemented by various numbers of hardware and/or software components that perform specific functions. For example, the functional blocks of the disclosure may be implemented by one or more microprocessors or by circuit elements for predetermined functions. In addition, for example, the functional blocks of the disclosure may be implemented by various programming or scripting languages. The functional blocks may be implemented as algorithms executed in one or more processors. In addition, the disclosure may employ the prior art for electronic environment configurations, signal processing, and/or data processing. Such terms as "mechanism", "element", "means", and "component" may be widely used, and are mot limited to mechanical and physical components.

Additionally, the connection lines or connection members between the elements illustrated in the drawings merely represent an example of functional connections and/or physical or circuit connections. In an actual device, the connections between elements may be represented through various alternative or additional functional, physical, or circuit connections.

Hereinafter, the disclosure will be described in detail with reference to the accompanying drawings.

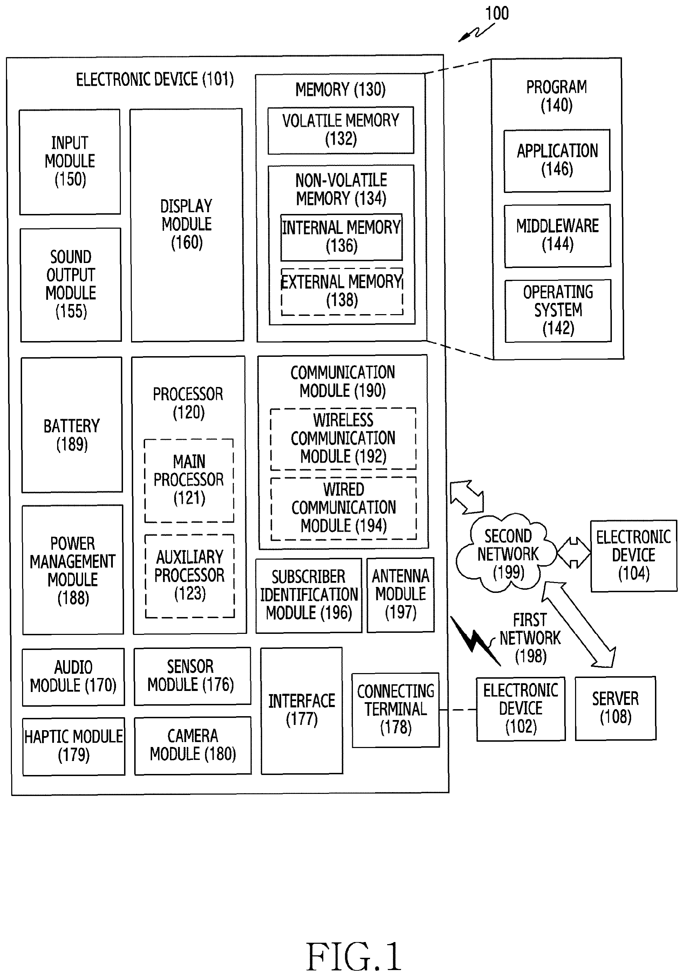

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

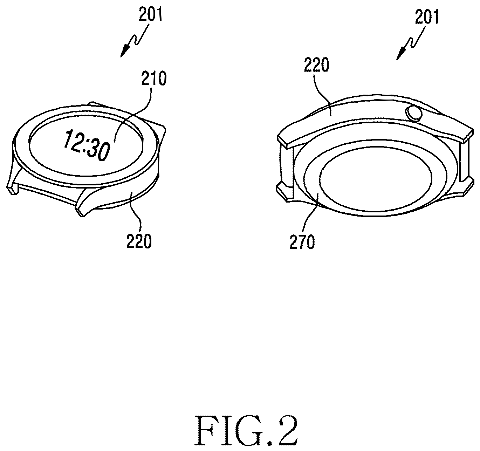

FIG. 2 is a perspective view of an electronic device according to an embodiment.

FIG. 2 illustratively illustrates a case in which the electronic device 201 is a watch-type wearable electronic device, but is not limited thereto.

In an embodiment, the electronic device 201 may be the electronic device 101 of FIG. 1. Referring to FIG. 2, the electronic device 201 may include an outer housing 220, a display device 210, and a rear cover 270.

The outer housing 220 according to an embodiment may include a first surface (hereinafter, a front surface) oriented in a first direction, a second surface (hereinafter, a rear surface) oriented in a second direction opposite to the first direction, and a side surface surrounding a space between the first surface and the second surface. The outer housing 220 may form an opening by having a through-hole of a predetermined size disposed at a center of the front surface. For example, the size of the through-hole may determine a size in which the display device 210 is exposed. In another example, the outer housing 220 may include a peripheral portion defining the through-hole, and a side wall that is perpendicular to, or has a predetermined angle with, the peripheral portion and surrounds the through-hole. In still another example, the outer housing 220 may protect various components disposed inside (e.g., the display device, a battery, or a printed circuit board). In FIG. 2, although a case in which the through-hole has a circular shape is illustratively shown, the present disclosure is not limited thereto.

According to an embodiment, an outer housing 220 may be coupled to a rear cover 270. In an embodiment, for example, a button or a crown may be additionally disposed on one side of the outer housing 220, and a fastening structure (not illustrated) configured to be detachable from a part of a user's body may be further included. The fastening structure may be implemented, for example, in the form of two band-shaped members respectively connected to opposite edge portions of the outer housing 220.

According to an embodiment, at least a portion of the outer housing 220 may be implemented using a conductive material (e.g., a metal). In this case, at least a portion of the outer housing 220 (hereinafter, a first conductive structure) may be used as an antenna radiator for transmitting and receiving data to and from an external device. For example, the first conductive structure may be used as an antenna of a mobile communication module of, for example, 2G, 3G, or 4G. Alternatively, the first conductive structure may be used as an antenna of a GPS communication module, a Wi-Fi communication module, an NFC communication module, or a Bluetooth communication module.

The first conductive structure according to an embodiment may be formed over an entire region of the outer housing 220, or may be formed in a portion thereof. For example, the first conductive structure may be formed in a peripheral region of the through-hole in which the display device 210 is exposed. In another example, the first conductive structure may be formed on a side wall of the outer housing 220.

According to an embodiment, the first conductive structure may include a feeding connection portion and various grounding connection portions. For example, the feeding connection portion and the various grounding connection portions may be connected to a printed circuit board inside the electronic device 201 or to various conductive structures. A manner in which an antenna radiator including the first conductive structure of the outer housing 220 operates will be described in more detail with reference to FIGS. 2 to 17, which will be described later.

According to an embodiment, the display device 210 may be exposed, at least in part, to the outside through the through-hole of the outer housing 220. The exposed display device 210 may have a shape corresponding to the shape of the through-hole (e.g., a circular shape). For example, the display device 210 may include a region exposed through the through-hole and a region seated inside the outer housing 220. For example, a separate glass member may be attached to the region exposed through the through-hole. In another example, the display device 210 may include a display panel (e.g., an LCD or an OLED) configured to display, for example, images or text, and a panel (e.g., a touch panel) configured to receive a user input. In an embodiment, the display device 210 may be implemented as a One-Cell TSP AMOLED (OCTA) in which a touch panel and an AMOLED panel are integrally combined.

According to an embodiment, the display device 210 may include a second conductive structure implemented using a conductive material (e.g., a metal). For example, the second conductive structure may be formed on a flexible printed circuit board (FPCB) included in the display device 210, or may be formed on a separate shielding layer or heat dissipation layer.

The second conductive structure according to an embodiment may be electrically connected to the first conductive structure included in the outer housing 220 or to a printed circuit board (e.g., a PCB), and may be utilized as a portion of an antenna. In an embodiment, the second conductive structure may include a plurality of conductive plates.

According to an embodiment, the rear cover 270 may be coupled to the outer housing 220 to fix and protect internal components. For example, the rear cover 270 may include a non-metallic material or a non-conductive material.

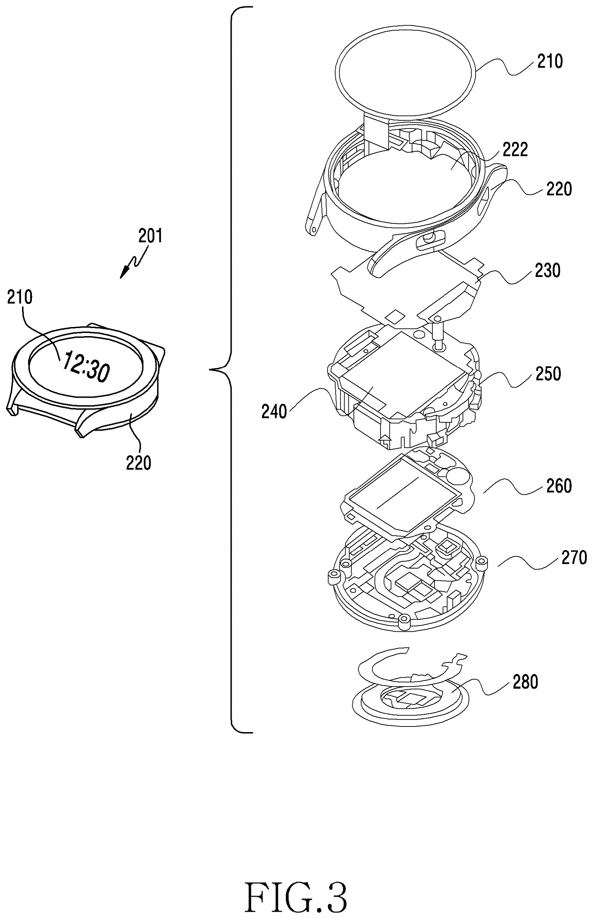

FIG. 3 is an exploded view of an electronic device according to an embodiment.

In an embodiment, the electronic device 201 may be the electronic device 101 of FIG. 1 or the electronic device 201 of FIG. 2.

Referring to FIG. 3, the electronic device 201 may include a display device 210, an outer housing 220, a support structure 230, a battery 240, a bracket 250, a printed circuit board 260, a rear cover 270, and/or a sensing module 280.

According to an embodiment, the outer housing 220 may protect various components disposed therein (e.g., the display device 210, the support structure 230, the battery 240, the bracket 250, or the printed circuit board 260).

The display device 210 according to an embodiment may have a plate shape as a whole and may display, for example, images or text. The display device 210 according to an embodiment may be implemented in various types such as an LCD type, an OLED type, or an OCTA type. When the display device 210 according to an embodiment includes a touch panel, the display device 210 may receive a user touch input and provide the input to a processor mounted on the printed circuit board 260. In an embodiment, the display device 210 may have various shapes such as a circular shape, an elliptical shape, or a rectangular shape.

According to an embodiment, the display device 210 may include a second conductive structure implemented using a conductive material (e.g., a metal). For example, the second conductive structure may be formed on a flexible printed circuit board (FPCB) included in the display device 210, or on a separate shielding layer or heat dissipation layer. The second conductive structure according to an embodiment may be connected to a first conductive structure of the outer housing 220 and/or the printed circuit board 260 and may be included as a part of a multi-band antenna.

According to an embodiment, the display device 210 may include a plurality of conductive plates (e.g., an FPCB, a shielding layer, or a heat dissipation layer). In an embodiment, the plurality of conductive plates may be connected to the printed circuit board 260 in order to secure antenna performance. For example, in the FPCB of the display device 210, a pattern may extend in a tail shape, and the tail-shaped pattern may be seated on the bracket 250 and may be connected to one surface of the printed circuit board 260. Through the connection between the plurality of conductive plates included in the display device 210 and the printed circuit board 260, it may be possible to prevent or reduce the display device 210 from acting as an interfering factor in radio-wave transmission and reception, and the display device 210 may be utilized for resonance-frequency tuning. In an embodiment, the plurality of conductive plates may form at least a portion of the second conductive structure.

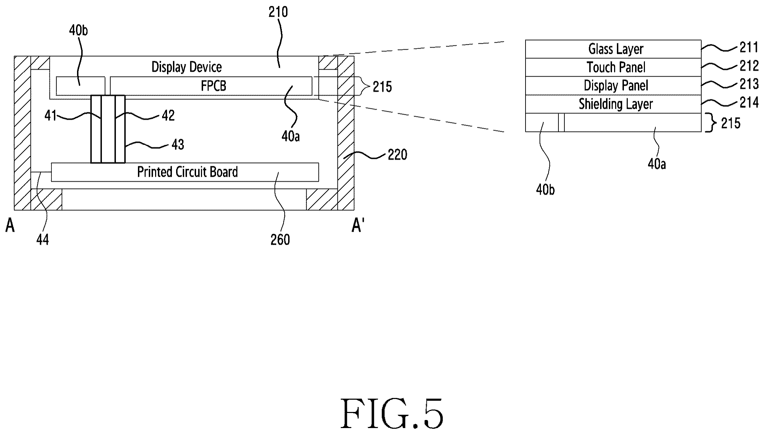

According to an embodiment, the display device 210 may be formed in a stacked structure including, for example, a touch panel, a display panel, an adhesive layer, and an FPCB layer. The stacked structure of the display device 210 according to an embodiment will be described in more detail with reference to FIG. 5 below.

The display device 210 according to an embodiment may include signal lines for transmitting and receiving data to and from the printed circuit board 260. For example, in the display device 210, signal lines related to signal supply of the display panel (e.g., an FPCB), signal lines related to signal supply of a touch screen, signal lines for NFC signal transmission and reception, or signal lines for grounding may be disposed to protrude.

According to an embodiment, the outer housing 220 may include a first conductive structure implemented using a conductive material (e.g., a metal) at least in part. For example, the first conductive structure may be formed in a portion having a height the same as or similar to the display device 210 (e.g., a side wall of the outer housing 220). Depending on the position of the first conductive structure according to an embodiment, characteristics of a corresponding resonance frequency may vary.

The support structure 230 according to an embodiment may be disposed between the display device 210 and the printed circuit board 260 to fix the display device 210. For example, the support structure 230 may be implemented, at least in part (hereinafter, a third conductive structure), using a conductive material (e.g., a metal material). In an embodiment, the third conductive structure may be a conductive plate positioned on an upper surface of the bracket 250, but is not limited thereto.

In an embodiment, the support structure 230 may be connected to a ground of the printed circuit board 260 or to the first conductive structure of the outer housing 220, and may be used to adjust frequency resonance characteristics.

The battery 240 according to an embodiment may be disposed on the bracket 250 and may be electrically connected to the printed circuit board 260. The battery 240 may receive charging power from an external power source and may discharge the charged power to drive the electronic device 201.

The bracket 250 according to an embodiment may be a structure on which, for example, the display device 210, the battery 240, or the printed circuit board 260 may be disposed and fixed. For example, signal lines for connecting respective components may be disposed on and fixed to the bracket 250. For example, the bracket 250 may be implemented using a non-conductive material (e.g., a plastic material). In an embodiment, a conductive structure (e.g., a conductive plate) may be included on one surface of the bracket 250 (e.g., a surface adjacent to the display device 210). In an embodiment, the conductive structure included on one surface of the bracket 250 may be connected to the printed circuit board 260 and may affect frequency resonance characteristics.

The printed circuit board 260 according to an embodiment may be a structure on which components such as modules or chips required for driving the electronic device 201 may be disposed. For example, a processor, a memory, or a communication module may be disposed on the printed circuit board 260. In an embodiment, the printed circuit board 260 may include a feeding portion that is electrically connected to an antenna radiator, and may include a separate ground.

The feeding portion according to an embodiment may be connected to the first conductive structure of the outer housing 220. In this case, the first conductive structure may operate as an antenna radiator and may be fed with power through the feeding portion from a wireless communication circuit in the printed circuit board 260.

The ground of the printed circuit board 260 according to an embodiment may be connected to conductive plates (e.g., an FPCB, a shielding layer, or a heat dissipation layer) included in the display device 210. In addition, the ground of the printed circuit board 260 may be connected to the first conductive structure included in the outer housing 220.

The rear cover 270 according to an embodiment may be coupled to the outer housing 220 to fix and protect internal components. For example, the rear cover 270 may include a non-metal material or a non-conductive material.

The sensing module 280 according to an embodiment may generate an electrical signal or a data value corresponding to an operation state inside the electronic device 201 or an environmental state outside the electronic device 201. For example, the sensing module 280 may include a bio-sensing module 280 (e.g., an HRM sensor) disposed on the second surface 110B of the housing 110. The electronic device 100 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

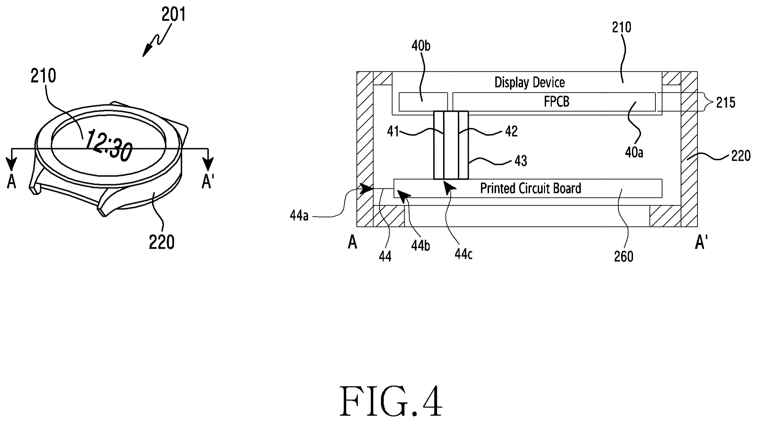

FIG. 4 is a cross-sectional view of an electronic device according to an embodiment.

The cross-sectional view of FIG. 4 illustrates main components related to the operation of an antenna, and additional components may further be provided in the cross-sectional view of FIG. 4.

Referring to FIG. 4, the electronic device 201 may include an outer housing 220 and a display device 210. In an embodiment, the electronic device 201 may include all or some of the components of the electronic device 101 illustrated in FIG. 1 or the electronic device 201 illustrated in FIG. 2.

The outer housing 220 may protect various components (e.g., the display device 210, the support structure 230, or the printed circuit board 260) disposed inside the outer housing 220. The outer housing 220 may include a through-hole 222 having a predetermined size at a central portion of a first surface (a front surface), and an opening may be formed by the through-hole 222. For example, the display device 210 may be exposed to the outside through the through-hole 222 of the outer housing 220.

According to an embodiment, the outer housing 220 may include, at least in part, a first conductive structure. For example, the first conductive structure may be formed over an entirety of the outer housing 220 or may be formed in a partial region thereof. The first conductive structure may be used as an antenna radiator for transmitting and receiving RF signals to and from an external device. The first conductive structure according to an embodiment may be formed on a side wall of the outer housing 220. The first conductive structure may be formed in various lengths and shapes and may be disposed at various positions, and frequency resonance characteristics of the antenna radiator including the first conductive structure may vary depending on a length, a shape, and a placement position of the first conductive structure.

In a case where the outer housing 220 according to an embodiment is utilized as an antenna radiator, the outer housing 220 may be connected to a communication circuit mounted on the printed circuit board 260 disposed inside the outer housing 220, and may transmit and receive predetermined signals. In an embodiment, for example, a size and a shape of the outer housing 220, and a bent portion thereof, may be modified in various forms according to communication characteristics of a communication module. The outer housing 220 may be connected to a feeding point 44a of the printed circuit board 260 through a feeding line 44. The feeding line 44 may be formed generally of a metal, and may include, in a partial section, an elastic structure (e.g., a c-clip, a spring, a leaf spring, a conductive sponge, a screw, or a spring washer).

According to an embodiment, the feeding point 44a of the outer housing 220 may be connected to an RF circuit (or an RF module) mounted on the printed circuit board 260. The outer housing 220 may be fed with power, through the feeding point 44a, from the RF circuit of the printed circuit board 260.

According to an embodiment, the outer housing 220 may also be connected to one or more grounds of the printed circuit board 260 through one or more grounding lines.

The feeding line 44 according to an embodiment may be implemented as a metal plate having contact portions at both ends. In another example, the contact portion may be formed of a material having elasticity and may be bent.

The display device 210 according to an embodiment may be exposed to the outside, at least in part, through the through-hole 222 of the outer housing 220. In an embodiment, the display device 210 may be implemented in a stacked structure. For example, the display device 210 may be in a form in which the glass layer 211, the touch panel 212, the display panel 213, the shielding layer 214, and/or the flexible printed circuit board (FPCB) layer 215 for driving the display panel are stacked, as will be described below. However, the stacked structure of the display device 210 is not limited thereto.

According to an embodiment, the display device 210 may include a second conductive structure. In an embodiment, the second conductive structure may form at least a portion of one layer among stacked layers of the display device. For example, the second conductive structure may be formed on at least a portion of the FPCB layer 215. For example, the second conductive structure may be formed on a first portion 40a of the FPCB layer 215, which will be described below.

According to an embodiment, the FPCB layer 215 may include a first portion 40a on which a chip and/or a module for performing operations of the electronic device 101 is mounted, and a second portion 40b that is divided (or separated) from the first portion 40a.

According to an embodiment, the second portion 40b of the FPCB layer 215 may be located in a portion of an edge of the FPCB layer 215, and a conductive member may be formed in the second portion 40b. For example, the conductive member may include at least one of a conductor or a conductive member. For example, the first portion 40a may be electrically separated from the conductive member of the second portion 40b. For example, the first portion 40a and the conductive member of the second portion 40b may be electrically separated from each other by not being connected with a conductive material.

According to an embodiment, although the first portion 40a is electrically separated from the conductive member formed in the second portion 40b, the conductive member formed in the second portion 40b of the FPCB layer 215 may be coupled to the first portion 40a of the FPCB layer 215, and thus the conductive member formed in the second portion 40b of the FPCB layer 215 may be capacitively connected to the first portion 40a of the FPCB layer 215. According to an embodiment, a capacitance may be formed between the conductive member formed in the second portion 40b of the FPCB layer 215 and the first portion 40a of the FPCB layer 215, and accordingly, by feeding power to the outer housing 220 of the electronic device 101, frequency resonance characteristics of an antenna radiator including at least a portion of the outer housing 220 of the electronic device 101 and the display device 210 may be adjusted. An E-field of a low-frequency band may be strongly formed between the display device 210 and the outer housing 220, and by forming the second portion 40b including a conductive member by dividing a portion of an edge of the FPCB layer 215 in which the E-field of the low-frequency band is strongly formed, it may be possible to adjust frequency resonance characteristics of the low-frequency band and to implement a low-frequency wideband. In addition, by using the conductive member included in the second portion 40b of the edge of the FPCB layer 215 in proximity to another portion of the display device 210 serving as a main radiator, it may be possible to adjust frequency resonance characteristics of the low-frequency band and to implement a low-frequency wideband.

The conductive member of the second portion 40b according to an embodiment may be connected to the printed circuit board 260. For example, the conductive member of the second portion 40b may be connected to the ground 44c of the printed circuit board 260 and may be used to adjust frequency resonance characteristics. Alternatively, for example, the conductive member of the second portion 40b may be connected to an RF circuit of the printed circuit board 260, and in this case, the second portion 40b may be fed with power by the RF circuit.

According to an embodiment, components such as modules or chips required for driving the electronic device 201 may be disposed on the printed circuit board 260. For example, a processor, a memory, or a communication module may be disposed on the printed circuit board 260. In an embodiment, components such as an RF circuit for communication, a control circuit, a feeding portion, or a ground may be disposed on the printed circuit board 260.

In an embodiment, the printed circuit board 260 may include a feeding portion 44b configured to transmit a communication signal (e.g., an RF signal) to an antenna radiator, and may include at least one ground 44c. The feeding portion 44b of the printed circuit board 260 may transmit an RF signal to a feeding point 44a of the outer housing 220 through a feeding line 44 of the outer housing 220.

According to an embodiment, the printed circuit board 260 may be connected to the display device 210 by a connector 43. For example, the connector 43 may include a grounding line 41 and a data line 42. The grounding line 41 may connect the ground 44c of the printed circuit board 260 to the second portion 40b of the FPCB layer 215. The data line 42 may connect the printed circuit board 260 to the first portion 40a of the FPCB layer 215. A video signal from the printed circuit board 260 may be provided to the first portion 40a of the FPCB layer 215 through the data line 42.

According to an embodiment, the grounding line 41 may be included in the connector 43 for providing a video signal from the printed circuit board 260 to the display device 210, but is not limited thereto. For example, the grounding line 41 may be implemented as a separate independent configuration, without being included in the connector 43 including the data line 42.

According to an embodiment, the grounding line 41 and/or the data line 42 may extend from the FPCB layer 215 in a tail shape. For example, the grounding line 41 and/or the data line 42 may be formed generally of a metal, and may include, in a partial section, an elastic structure (e.g., a c-clip, a spring, a leaf spring, a conductive sponge, a screw, or a spring washer).

FIG. 5 is a cross-sectional view of a display device according to an embodiment.

Referring to FIG. 5, the display device 210 according to an embodiment may include a glass layer 211, a touch panel 212, a display panel 213, a shielding layer 214, and/or an FPCB layer 215.

The glass layer 211 according to an embodiment may protect the display device 210 from the outside.

The touch panel 212 according to an embodiment may detect a user touch input (or a touch pen input). For example, the touch panel 212 may provide a change in a signal (e.g., a change in capacitance) according to a touch input to a processor (e.g., 120) on the printed circuit board 260. According to an embodiment, the touch panel 212 may include a touch signal line directly connected to the printed circuit board 260. According to an embodiment, the touch panel 212 may be connected to a ground of the printed circuit board 260 and may operate as a ground layer, but is not limited thereto.

The display panel 213 according to an embodiment may output, for example, an image or text.

The shielding layer 214 according to an embodiment may block an influence caused by electromagnetic waves.

According to an embodiment, modules or chips required for driving the display panel 213 may be mounted on the FPCB layer 215. At least a portion of the FPCB layer 215 according to an embodiment may be connected to a ground of the printed circuit board 260 and may operate as a ground. According to an embodiment, the FPCB layer 215 may be connected to the printed circuit board 260 through a data line 42 configured to transmit and receive data. For example, a first portion 40a of the FPCB layer 215 may be connected to the printed circuit board 260 through the data line 42. For example, the data line 42 may be included in the connector 43.

The FPCB layer 215 according to an embodiment may include a first portion 40a on which a chip and/or a module configured to perform an operation of the display panel 213 is mounted, and a second portion 40b that is divided (or separated) from the first portion 40a. For example, the first portion 40a and the second portion 40b may be electrically separated.

According to an embodiment, the second portion 40b may be located in a portion of an edge of the FPCB layer 215, and a conductive member may be formed in the second portion 40b. According to an embodiment, although the first portion 40a and the second portion 40b are electrically separated from each other, the conductive member formed in the second portion 40b of the FPCB layer 215 may be coupled to the first portion 40a of the FPCB layer 215, and thus the conductive member formed in the second portion 40b of the FPCB layer 215 may be capacitively connected to the first portion 40a of the FPCB layer 215. According to an embodiment, a capacitance may be formed between the conductive member formed in the second portion 40b of the FPCB layer 215 and the first portion 40a of the FPCB layer 215, and accordingly, by feeding power to the outer housing 220 of the electronic device 101, frequency resonance characteristics of an antenna radiator including at least a portion of the outer housing 220 of the electronic device 101 and the display device 210 may be adjusted.

According to an embodiment, an E-field of a low-frequency band may be strongly formed between the display device 210 and the outer housing 220, and by forming a conductive member by dividing a portion of an edge of the FPCB layer 215 of the display device 210, it may be possible to adjust frequency resonance characteristics of the low-frequency band and to implement a low-frequency wideband. In addition, by using the conductive member included in the second portion 40b of the edge of the FPCB layer 215 in proximity to another portion of the display device 210 serving as a main radiator, it may be possible to adjust frequency resonance characteristics of the low-frequency band and to implement a low-frequency wideband.

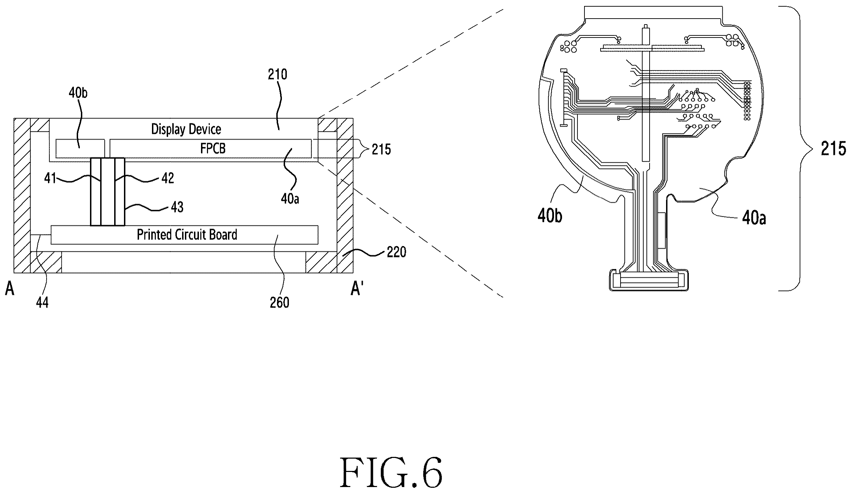

FIG. 6 is a view illustrating divided first and second portions of an FPCB according to an embodiment.

Referring to FIG. 6, an FPCB layer 215 of the display device 210 according to an embodiment may have a shape including an arc, in accordance with a shape of an inner surface of the outer housing 220 of the electronic device 101. A second portion 40b may be formed in a portion of an edge of the FPCB layer 215, and the second portion 40b may be electrically divided (or separated) from a first portion 40a of the FPCB layer 215. A conductive member may be formed in the second portion 40b.

According to an embodiment, the conductive member formed in the second portion 40b may not be connected to the first portion 40a of the FPCB layer 215 by a conductive material. According to an embodiment, the conductive member formed in the second portion 40b may be coupled to the first portion 40a of the FPCB layer 215. For example, the conductive member formed in the second portion 40b may be coupled to a conductive structure in the first portion 40a of the FPCB layer 215, but is not limited thereto.

According to an embodiment, by feeding power to the outer housing 220, a capacitance may be formed between the conductive member formed in the second portion 40b and the first portion 40a. For example, a capacitance may be formed between the conductive member formed in the second portion 40b and the conductive structure in the first portion 40a.

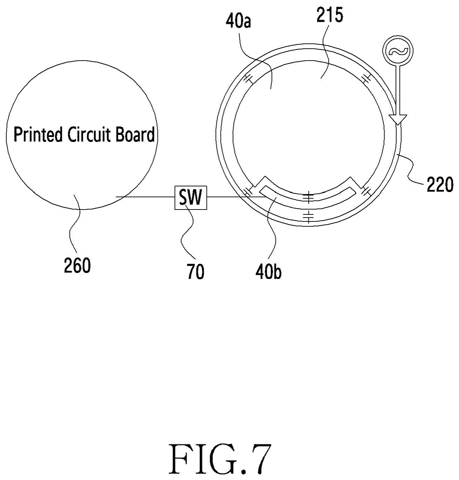

FIG. 7 is a view illustrating an example in which an electrical length of an antenna radiator including at least a portion of an outer housing and a display device is adjusted as the outer housing is fed with power, according to an embodiment.

Referring to FIG. 7, a conductive member of a second portion 40b of an FPCB layer 215 according to an embodiment may be connected to a printed circuit board 260 through a switch 70. The conductive member of the second portion 40b of the FPCB layer 215 may be connected to a ground of the printed circuit board 260 through the switch 70. For example, when the switch 70 is shorted and the outer housing 220 is fed with power from the printed circuit board 260, the outer housing 220, a first portion 40a of the FPCB layer 215, and the second portion 40b of the FPCB layer 215 may be coupled to each other. For example, a conductive structure of the outer housing 220 and the first portion 40a of the FPCB layer 215 may be coupled to each other, the conductive structure of the outer housing 220 and the second portion 40b of the FPCB layer 215 may be coupled to each other, and the first portion 40a of the FPCB layer 215 and the second portion 40b of the FPCB layer 215 may be coupled to each other. For example, as the outer housing 220, the first portion 40a of the FPCB layer 215, and the second portion 40b of the FPCB layer 215 are coupled to each other, a capacitance may be formed between the conductive structure of the outer housing 220 and the first portion 40a of the FPCB layer 215, a capacitance may be formed between the conductive structure of the outer housing 220 and the second portion 40b of the FPCB layer 215, and a capacitance may be formed between the first portion 40a of the FPCB layer 215 and the second portion 40b of the FPCB layer 215.

According to an embodiment, as the switch 70 is shorted or opened, an electrical length of an antenna radiator including at least a portion of the outer housing 220 and the display device 210 may be adjusted, and frequency resonance characteristics of the antenna radiator may be adjusted.

In FIG. 7, although the switch 70 is illustrated as being disposed outside the printed circuit board 260, it is not limited thereto. For example, the switch 70 may be disposed on the printed circuit board 260. For example, the switch 70 may be connected to a ground through lumped elements on the printed circuit board 260.

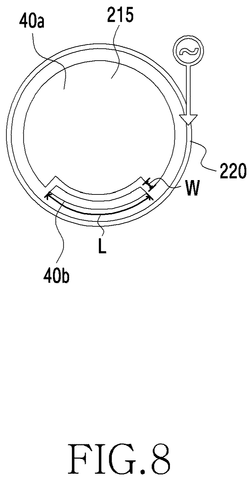

FIG. 8 is a view illustrating a length and a width of a conductive member formed in a second portion of an FPCB according to an embodiment.

Referring to FIG. 8, a length and a width of a conductive member of a second portion 40b of the FPCB layer 215 according to an embodiment may be formed so as to allow the electronic device 101 to adjust frequency resonance characteristics of a low-frequency band.

For example, the conductive member of the second portion 40b of the FPCB layer 215 may be formed in the divided second portion 40b of the FPCB layer 215 such that the length of the conductive member of the second portion 40b of the FPCB layer 215 is about 10 mm or more and the width of the conductive member of the second portion 40b of the FPCB layer 215 is about 1 mm or more.

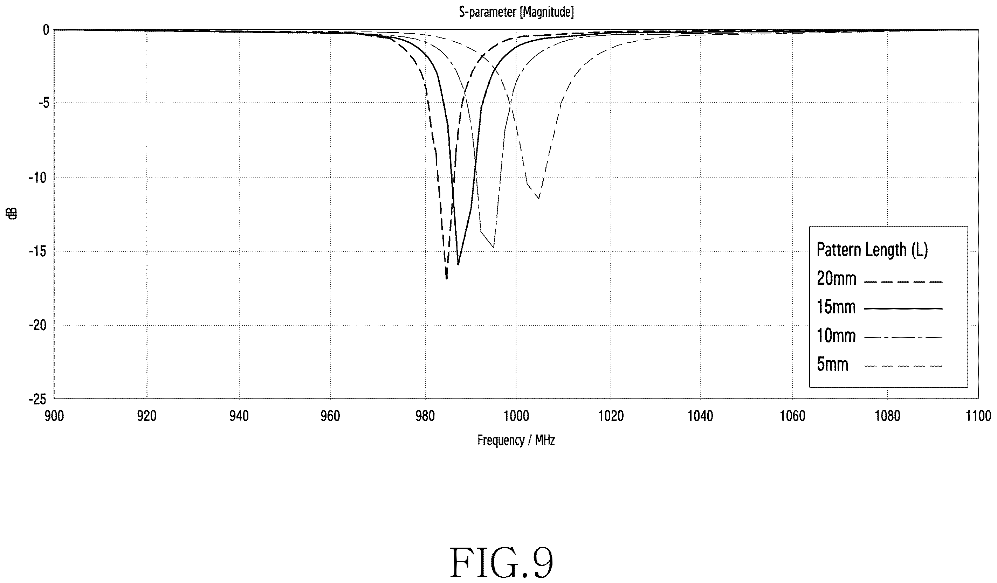

FIG. 9 is a view illustrating radiation performance of an antenna radiator according to a length of a conductive member formed in the second portion of an FPCB according to an embodiment.

Referring to FIG. 9, the graphs of FIG. 9 illustrate radiation performance of antenna radiators in a case where the length of the conductive member of the second portion 40b of the FPCB layer 215 is 20 mm, in a case where the length of the conductive member of the second portion 40b of the FPCB layer 215 is 15 mm, in a case where the length of the conductive member of the second portion 40b of the FPCB layer 215 is 10 mm, and in a case where the length of the conductive member of the second portion 40b of the FPCB layer 215 is 5 mm.

As illustrated in FIG. 9, when the length of the conductive member of the second portion 40b of the FPCB layer 215 is 10 mm or more, the antenna radiator may have good radiation performance in a frequency band of 980 MHz to 1000 MHz. For example, as the length of the conductive member of the second portion 40b increases, a resonance frequency of the antenna including the conductive structure of the outer housing 220 may decrease.

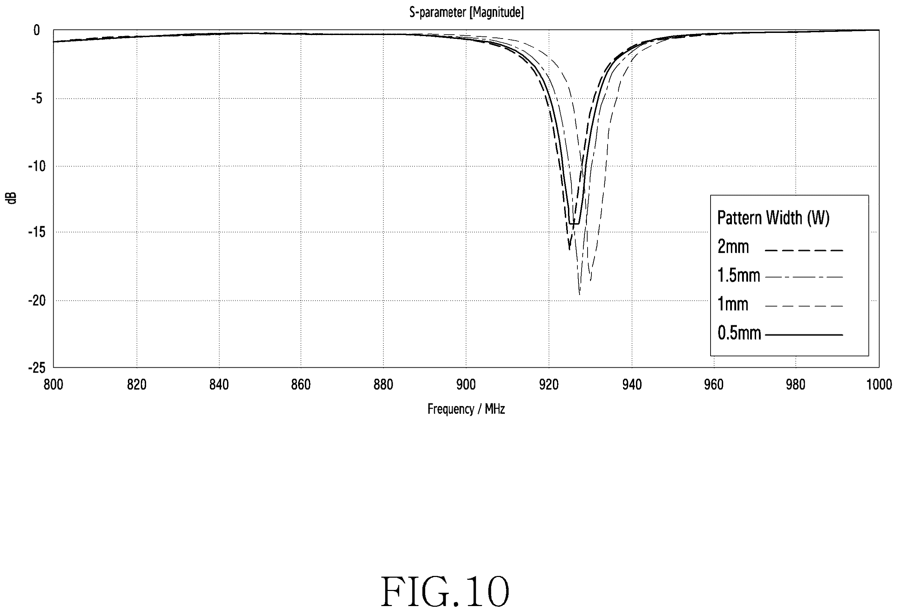

FIG. 10 is a view illustrating radiation performance of an antenna radiator according to the width of the conductive member formed in the second portion of an FPCB according to an embodiment.

Referring to FIG. 10, the graphs of FIG. 10 illustrate radiation performance of antenna radiators in a case where the width of the conductive member of the second portion 40b of the FPCB layer 215 is 2 mm, in a case where the width of the conductive member of the second portion 40b of the FPCB layer 215 is 1.5 mm, in a case where the width of the conductive member of the second portion 40b of the FPCB layer 215 is 1 mm, and in a case where the width of the conductive member of the second portion 40b of the FPCB layer 215 is 0.5 mm.

As illustrated in FIG. 10, when the width of the conductive member of the second portion 40b of the FPCB layer 215 is 1 mm or more, the antenna radiator may have good radiation performance in a frequency band of 920 MHz to 940 MHz. For example, even when the width of the conductive member of the second portion 40b is changed, a resonance frequency of the antenna including the conductive structure of the outer housing 220 may be substantially similar. For example, the width of the conductive member of the second portion 40b may have less effect on the resonance frequency of the antenna including the conductive structure of the outer housing 220, compared to the length of the conductive member of the second portion 40b.

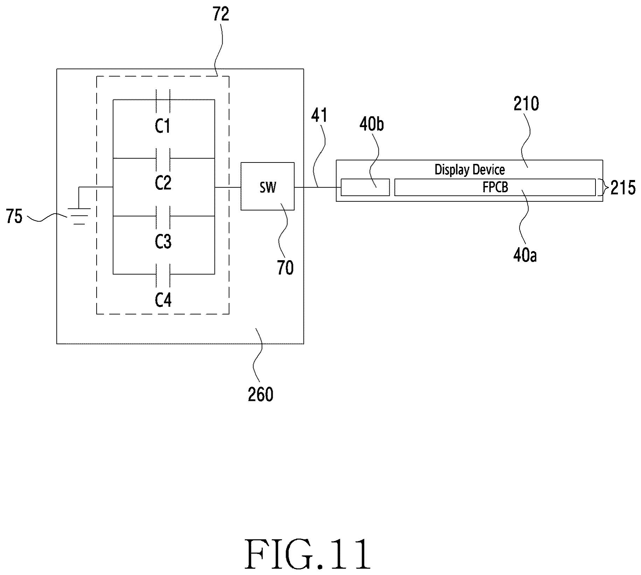

FIG. 11 is a view illustrating an example in which a conductive member formed in a second portion of an FPCB and a matching circuit of a printed circuit board are connected by a switch according to an embodiment.

Referring to FIG. 11, the second portion 40b of the FPCB layer 215 according to an embodiment may be connected to a switch 70 on the printed circuit board 260 through a grounding line 41. The grounding line 41 may be made generally of a metal and may include, in a partial section, an elastic structure (e.g., a c-clip, a spring, a plate spring, a conductive sponge, a screw, or a spring washer).

According to an embodiment, the switch 70 may be connected to the matching circuit 72 on the printed circuit board 260, and the matching circuit 72 may be connected to a ground 75 on the printed circuit board 260.

The matching circuit 72 may include at least one lumped element and may include, for example, a plurality of capacitors C1, C2, C3, and C4. For example, the matching circuit 72 may include the plurality of capacitors C1, C2, C3, and C4 connected in parallel to each other, and may be disposed between the switch 70 and the ground 75. However, the disclosure is not limited thereto, and, for example, the matching circuit 72 may include at least one of another lumped element (e.g., an inductor or a variable capacitor) or another switch.

In an embodiment, capacitors C1, C2, C3, and C4 having different capacitances may be included in the matching circuit 72. By disposing the capacitors C1, C2, C3, and C4 having different capacitance values in the matching circuit 72 and controlling shorting and opening of the switch 70, frequency resonance characteristics of an antenna radiator including at least a portion of the outer housing 220 and the display device 210 may be adjusted. For example, frequency resonance characteristics of a low-frequency band of the antenna radiator including at least a portion of the outer housing 220 and the display device 210 may be adjusted.

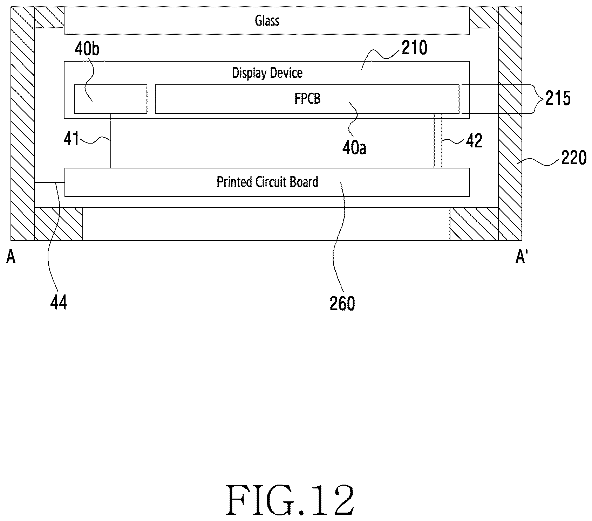

FIG. 12 is a view illustrating wire connections between a display device and a printed circuit board according to an embodiment.

Referring to FIG. 12, a first portion 40a and a second portion 40b of the FPCB layer 215 in the display device 210 according to an embodiment may be connected to the printed circuit board 260 through respective different electrical paths. For example, the first portion 40a of the FPCB layer 215 in the display device 210 may be connected to the printed circuit board 260 through a data line 42, and the second portion 40b of the FPCB layer 215 may be connected to the printed circuit board 260 through a grounding line 41. For example, the first portion 40a of the FPCB layer 215 in the display device 210 may be connected to a ground of the printed circuit board 260 through the data line 42 (e.g., a display connector). The grounding line 41 and the data line 42 may be spaced apart from each other and may be formed as separate lines.

For example, the second portion 40b of the FPCB layer 215 may be connected to the printed circuit board 260 through the grounding line 41. For example, the second portion 40b of the FPCB layer 215 may be connected to a ground 75 of the printed circuit board 260 through the grounding line 41. For example, the second portion 40b of the FPCB layer 215 may be connected to a switch 70 on the printed circuit board 260 through the grounding line 41, and the switch 70 may be connected to the ground 75 of the printed circuit board 260. For example, the second portion 40b of the FPCB layer 215 may be connected to the switch 70 on the printed circuit board 260 through the grounding line 41, the switch 70 may be connected to a matching circuit 72 on the printed circuit board 260, and the matching circuit 72 may be connected to the ground 75 on the printed circuit board 260.

For example, the first portion 40a of the FPCB layer 215 may be connected to the printed circuit board 260 through the data line 42. For example, image data may be provided to the display device 210 through the data line 42.

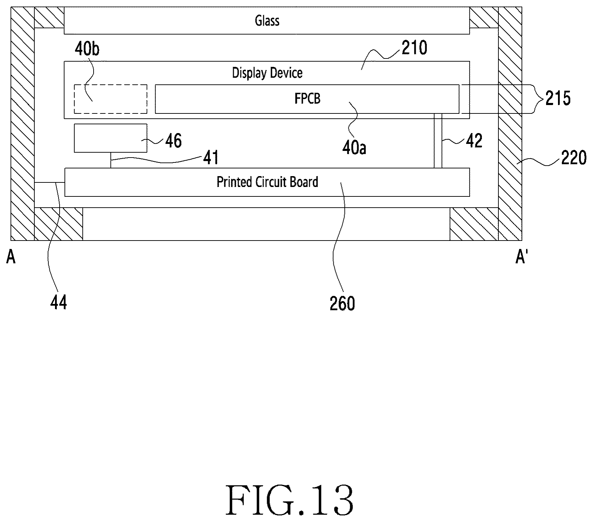

FIG. 13 is a view illustrating wire connections among a conductive member disposed under a display device, the display device, and a printed circuit board according to an embodiment.

Referring to FIG. 13, a conductive member may not be present in a second portion 40b of an FPCB layer 215 in the display device 210 according to an embodiment. For example, a conductive member 46 may be disposed under the second portion 40b of the FPCB layer 215 in the display device 210 such that the conductive member 46 is not included in the FPCB layer 215. For example, the second portion 40b of the FPCB layer 215 may include a fill-cut region. In this case, for example, the conductive member 46 disposed under the first portion 40a of the FPCB layer 215 may be connected to the printed circuit board 260 through a grounding line 41. For example, the conductive member 46 disposed under the second portion 40b of the FPCB layer 215 may be connected to a ground 75 of the printed circuit board 260 through the grounding line 41. For example, the conductive member 46 disposed under the second portion 40b of the FPCB layer 215 may be connected to a switch 70 on the printed circuit board 260 through the grounding line 41, and the switch 70 may be connected to the ground 75 of the printed circuit board 260. For example, the conductive member 46 disposed under the second portion 40b of the FPCB layer 215 may be connected to the switch 70 on the printed circuit board 260 through the grounding line 41, the switch 70 may be connected to a matching circuit 72 on the printed circuit board 260, and the matching circuit 72 may be connected to the ground 75 on the printed circuit board 260.

For example, the first portion 40a of the FPCB layer 215 may be connected to the printed circuit board 260 through a data line 42. For example, image data may be provided to the display device 210 through the data line 42.

According to an embodiment, the conductive member 46 disposed under the second portion 40b of the FPCB layer 215 may be coupled to the first portion 40a of the FPCB layer 215.

In an embodiment, the conductive member 46 may be disposed in the display device 210.

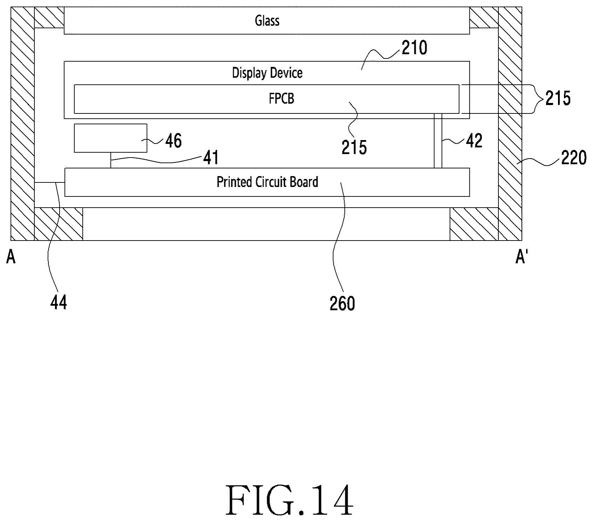

FIG. 14 is a view illustrating wire connections among a conductive member disposed under a display device, the display device, and a printed circuit board according to an embodiment.

Referring to FIG. 14, an FPCB layer 215 of the display device 210 according to an embodiment may not be divided. For example, the FPCB layer 215 of the display device 210 may not be divided into a first portion 40a and a second portion 40b. For example, a conductive member included in the first portion 40a may extend to the second portion 40b. In this case, a conductive member 46 may be disposed under a portion of an edge of the FPCB layer 215 of the display device 210. In this case, for example, the conductive member 46 disposed under the portion of the edge of the FPCB layer 215 may be connected to the printed circuit board 260 through a grounding line 41. For example, the conductive member 46 disposed under the portion of the edge of the FPCB layer 215 may be connected to a ground 75 of the printed circuit board 260 through the grounding line 41. For example, the conductive member 46 disposed under the portion of the edge of the FPCB layer 215 may be connected to a switch 70 on the printed circuit board 260 through the grounding line 41, and the switch 70 may be connected to the ground 75 of the printed circuit board 260. For example, the conductive member 46 disposed under the portion of the edge of the FPCB layer 215 may be connected to the switch 70 on the printed circuit board 260 through the grounding line 41, the switch 70 may be connected to a matching circuit 72 on the printed circuit board 260, and the matching circuit 72 may be connected to the ground 75 on the printed circuit board 260.

For example, the FPCB layer 215 may be connected to the printed circuit board 260 through a data line 42. Image data may be provided to the display device 210 through the data line 42.

According to an embodiment, the conductive member 46 disposed under the portion of the edge of the FPCB layer 215 may be coupled to the conductive member included in the FPCB layer 215. For example, the conductive member may be a ground layer of the FPCB layer 215.

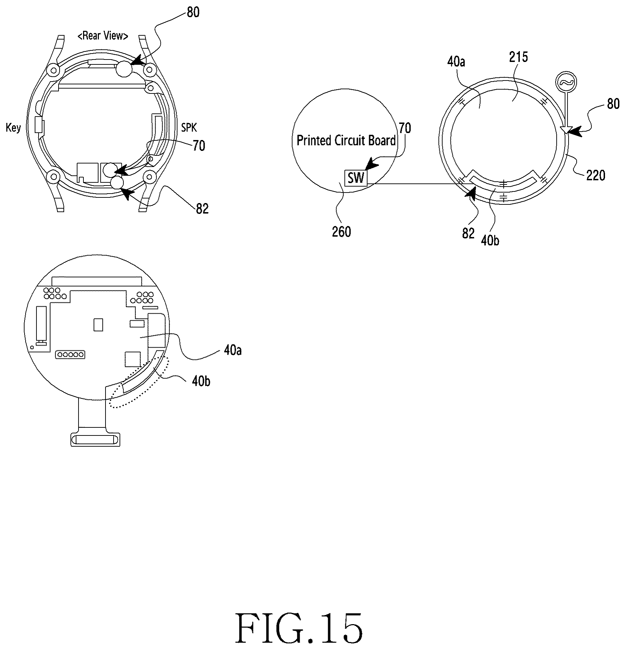

FIG. 15 is a view illustrating examples of arrangement positions of a feeding point, a grounding point, and a switch of an electronic device according to an embodiment.

Referring to FIG. 15, power may be fed to a first point 80 of the outer housing 220 of the electronic device 101 according to an embodiment, and a second point 82 of a second portion 40b of the FPCB layer 215 may be connected to a printed circuit board 260 through a switch 70. According to an embodiment, the first point 80 may be a feeding point, and the second point 82 may be a ground point.

For example, based on the drawing of FIG. 15, the first point 80 may be located near an upper-right portion of the outer housing 220, and the second point 82 may be located near a lower-right portion of the outer housing 220 in the second portion 40b of the FPCB layer 215.

For example, when power is fed to the first point 80 of the outer housing 220, the second point 82 of the FPCB layer 215 is connected to the printed circuit board 260 through the switch 70, and the switch 70 is shorted, the outer housing 220, the first portion 40a of the FPCB layer 215, and the second portion 40b of the FPCB layer 215 may be coupled to each other. For example, capacitances may be formed among the outer housing 220, the first portion 40a of the FPCB layer 215, and the second portion 40b of the FPCB layer 215, and low-frequency resonance characteristics of an antenna radiator including at least a portion of the outer housing 220 and the display device 210 may be adjusted.

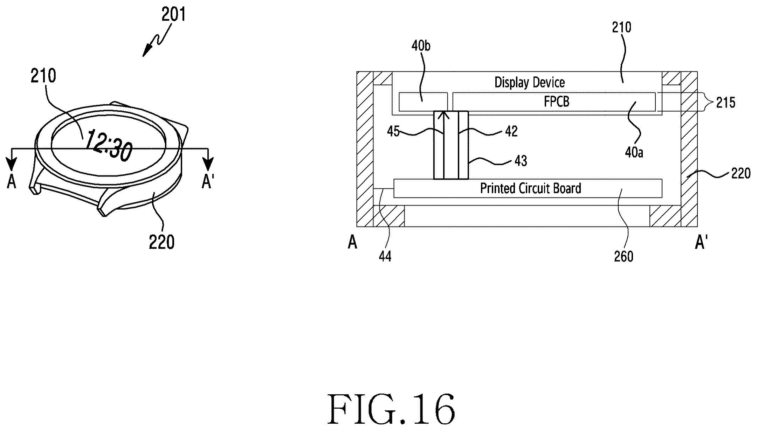

FIG. 16 is a view illustrating an example in which a conductive member formed in a second portion of an FPCB is fed with power, according to an embodiment.

The cross-sectional view of FIG. 16 illustrates main components related to the operation of an antenna, and additional components may further be provided in the cross-sectional view of FIG. 16.

Referring to FIG. 16, a conductive member formed in the second portion 40b of the FPCB layer 215 may be connected to an RF circuit of a printed circuit board 260 by a feeding line 45. In this case, the conductive member formed in the second portion 40b of the FPCB layer 215 may be fed with power through the feeding line 45. For example, the feeding line 45 may be formed generally of a metal, and may include, in a partial section, an elastic structure (e.g., a c-clip, a spring, a leaf spring, a conductive sponge, a screw, or a spring washer).

According to an embodiment, the feeding line 45 may be included in the connector 43 for providing a video signal from the printed circuit board 260 to the display device 210, but is not limited thereto. For example, the feeding line 45 may be implemented as a separate independent configuration, without being included in the connector 43 including the data line 42.

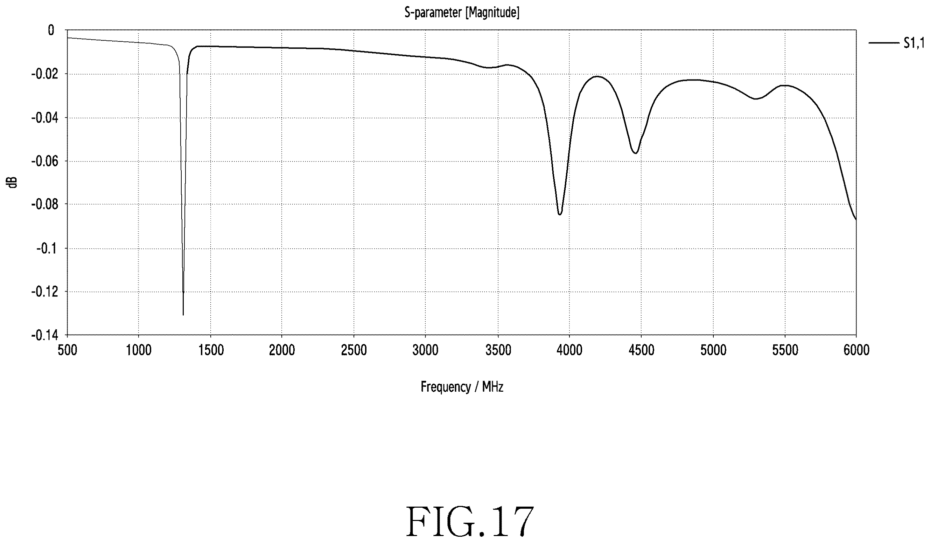

FIG. 17 is a view illustrating performance of an antenna radiator in a case where power is fed to the conductive member formed in the second portion of the FPCB according to an embodiment.

Referring to FIG. 17, when power is fed to the conductive member formed in the second portion 40b of the FPCB layer 215, an antenna radiator including the conductive member formed in the second portion 40b of the FPCB layer 215 may have good radiation performance in a frequency band of 1000 MHz to 1500 MHz.

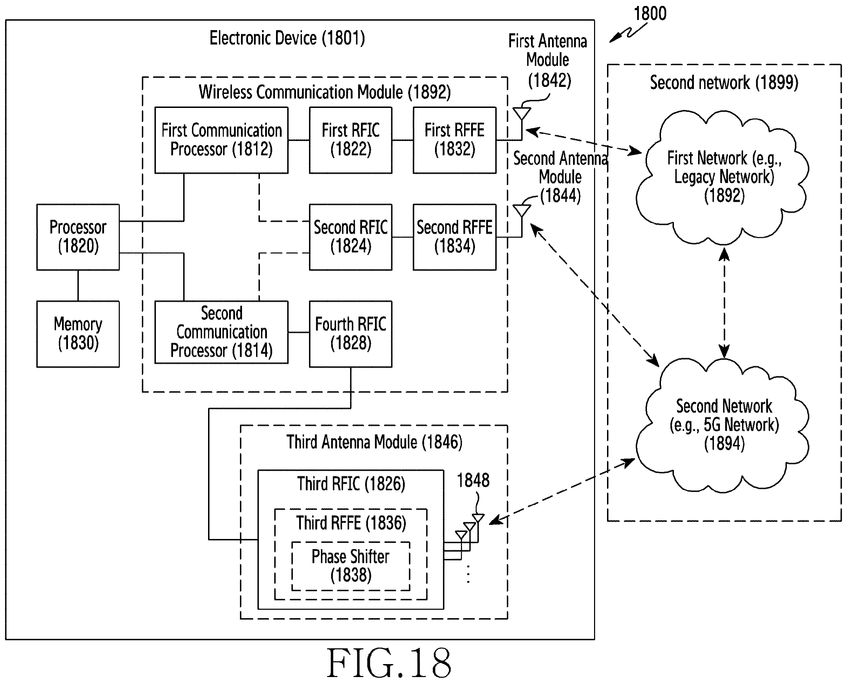

FIG. 18 is a block diagram 1800 of an electronic device configured to support legacy network communication and 5G network communication according to various embodiments of the disclosure. Referring to FIG. 18, an electronic device 101 may include a first communication processor (e.g., including processing circuitry) 1812, a second communication processor (e.g., including processing circuitry) 1814, a first radio frequency integrated circuit (RFIC) 1822, a second RFIC 1824, a third RFIC 1826, a fourth RFIC 1828, a first radio frequency front end (RFFE) 1832, a second RFFE 1834, a first antenna module 1842, a second antenna module 1844, and an antenna 1848. The electronic device 101 may further include a processor (e.g., including processing circuitry) 120 and a memory 130. The second network 199 may include a first cellular network 1892 and a second cellular network 1894. According to another embodiment, the electronic device may further include at least one of the parts shown in FIG. 1 and the second network 199 may further include at least one another network. According to an embodiment, the first communication processor 1812, the second communication processor 1814, the first RFIC 1822, the second RFIC 1824, the fourth RFIC 1828, the first RFFE 1832, and the second RFFE 1834 may form at least a portion of a wireless communication module 192. According to another embodiment, the fourth RFIC 1828 may be omitted or may be included as a portion of the third RFIC 1826.

The first communication processor 1812 can support establishment of a communication channel with a band to be used for wireless communication with the first cellular network 1892 and legacy network communication through the established communication channel. According to various embodiments, the first cellular network may be a legacy network including a 2G, 3G, 4G, or Long-Term Evolution (LTE) network. The second communication processor 1814 can support establishment of a communication channel corresponding to a designated band (e.g., about 6GHz ~ about 60GHz) of a band to be used for wireless communication with the second cellular network 1894 and 5G network communication through the established communication channel. According to various embodiments, the second cellular network 1894 may be a 5G network that is defined in 3GPP. Further, according to an embodiment, the first communication processor 1812 or the second communication processor 1814 can support establishment of a communication channel corresponding to another designated band (e.g., about 6GHz or less) of a band to be used for wireless communication with the second cellular network 1894 and 5G network communication through the established communication channel. According to an embodiment, the first communication processor 1812 and the second communication processor 1814 may be implemented in a single chip or a single package. According to various embodiments, the first communication processor 1812 or the second communication processor 1814 may be disposed in a single chip or a single package together with the processor 120, the auxiliary processor 123, or the communication module 190. According to an embodiment, the first communication processor 1812 and the second communication processor 1814 is directly or indirectly connected by an interface (not shown), thereby being able to provide or receive data or control signal in one direction or two directions.

The first RFIC 1822, in transmission, can converts a baseband signal generated by the first communication processor 1812 into a radio frequency (RF) signal of about 700MHz to about 3GHz that is used for the first cellular network 1892 (e.g., a legacy network). In reception, an RF signal can be obtained from the first cellular network 1892 (e.g., a legacy network) through an antenna (e.g., the first antenna module 1842) and can be preprocessed through an RFFE (e.g., the first RFFE 1832). The first RFIC 1822 can covert the preprocessed RF signal into a baseband signal so that the preprocessed RF signal can be processed by the first communication processor 1812.

The second RFIC 1824 can convert a baseband signal generated by the first communication processor 1812 or the second communication processor 1814 into an RF signal in a Sub6 band (e.g., about 6GHz or less) (hereafter, 5G Sub6 RF signal) that is used for the second cellular network 1894 (e.g., a 5G network). In reception, a 5G Sub6 RF signal can be obtained from the second cellular network 1894 (e.g., a 5G network) through an antenna (e.g., the second antenna module 1844) and can be preprocessed through an RFFE (e.g., the second RFFE 1834). The second RFIC 1824 can convert the processed 5G Sub6 RF signal into a baseband signal so that the processed 5G Sub6 RF signal can be processed by a corresponding communication processor of the first communication processor 1812 or the second communication processor 1814.

The third RFIC 1826 can convert a baseband signal generated by the second communication processor 1814 into an RF signal in a 5G Above6 band (e.g., about 6GHz ~ about 60GHz) (hereafter, 5G Above6 RF signal) that is used for the second cellular network 1894 (e.g., a 5G network). In reception, a 5G Above6 RF signal can be obtained from the second cellular network 1894 (e.g., a 5G network) through an antenna (e.g., the antenna 1848) and can be preprocessed through the third RFFE 1836. The third RFIC 1826 can covert the preprocessed 5G Above6 RF signal into a baseband signal so that the preprocessed 5G Above6 RF signal can be processed by the first communication processor 1814. According to an embodiment, the third RFFE 1836 may be provided as a portion of the third RFIC 1826.

The electronic device 101, according to an embodiment, may include a fourth RFIC 1828 separately from or as at least a portion of the third RFIC 1826. In this case, the fourth RFIC 1828 can convert a baseband signal generated by the second communication processor 1814 into an RF signal in an intermediate frequency band (e.g., about 9GHz ~ about 11GHz) (hereafter, IF signal), and then transmit the IF signal to the third RFIC 1826. The third RFIC 1826 can convert the IF signal into a 5G Above6 RF signal. In reception, a 5G Above6 RF signal can be received from the second cellular network 1894 (e.g., a 5G network) through an antenna (e.g., the antenna 1848) and can be converted into an IF signal by the third RFIC 1826. The fourth RFIC 1828 can covert the IF signal into a baseband signal so that IF signal can be processed by the second communication processor 1814.

According to an embodiment, the first RFIC 1822 and the second RFIC 1824 may be implemented as at least a portion of a single chip or a single package. According to an embodiment, the first RFFE 1832 and the second RFFE 1834 may be implemented as at least a portion of a single chip or a single package. According to an embodiment, at least one of the first antenna module 1842 or the second antenna module 1844 may be omitted, or may be combined with another antenna module and can process RF signals in a plurality of bands.

According to an embodiment, the third RFIC 1826 and the antenna 1848 may be disposed on a substrate, thereby being able to form a third antenna module 1846. For example, the wireless communication module 192 or the processor 120 may be disposed on a first substrate (e.g., a main PCB). In this case, the third RFIC 1826 may be disposed in a partial area (e.g., the bottom) and the antenna 1848 may be disposed in another partial area (e.g., the top) of a second substrate (e.g., a sub PCB) that is different from the first substrate, thereby being able to form the third antenna module 1846. By disposing the third RFIC 1826 and the antenna 1848 on the same substrate, it is possible to reduce the length of the transmission line therebetween. Accordingly, it is possible to reduce a loss (e.g., attenuation) of a signal in a high-frequency band (e.g., about 6GHz ~ about 60 GHz), for example, which is used for 5G network communication, due to a transmission line. Accordingly, the electronic device 101 can improve the quality and the speed of communication with the second cellular network 1894 (e.g., 5G network).

According to an embodiment, the antenna 1848 may be an antenna array including a plurality of antenna elements that can be used for beamforming. In this case, the third RFIC 1826, for example, as a portion of the third RFFE 1836, may include a plurality of phase shifters 1838 corresponding to the antenna elements. In transmission, the phase shifters 1838 can convert the phase of a 5G Above6 RF signal to be transmitted to the outside of the electronic device 101 (e.g., to a base station of a 5G network) through the respectively corresponding antenna elements. In reception, the phase shifters 1838 can convert the phase of a 5G Above6 RF signal received from the outside through the respectively corresponding antenna element into the same or substantially the same phase. This enables transmission or reception through beamforming between the electronic device 101 and the outside.

The second cellular network 1894 (e.g., a 5G network) may be operated independently from (e.g., Stand-Along (SA)) or connected and operated with (e.g., Non-Stand Along (NSA)) the first cellular network 1892 (e.g., a legacy network). For example, there may be only an access network (e.g., a 5G radio access network (RAN) or a next generation RAN (NG RAN)) and there is no core network (e.g., a next generation core (NGC)) in a 5G network. In this case, the electronic device 101 can access the access network of the 5G network and then can access an external network (e.g., the internet) under control by the core network (e.g., an evolved packed core (EPC)) of the legacy network. Protocol information (e.g., LTE protocol information) for communication with a legacy network or protocol information (e.g., New Radio (NR) protocol information) for communication with a 5G network may be stored in the memory 1830 and accessed by another part (e.g., the processor 120, the first communication processor 1812, or the second communication processor 1814).

An electronic device according to an embodiment may include an outer housing 220 including a first surface oriented in a first direction, a second surface oriented in a second direction opposite to the first direction, and a side surface surrounding a space between the first surface and the second surface, and a display device 210 which is exposed, at least in part, through the first surface of the outer housing. The display device may include a plurality of layers including a flexible printed circuit board (FPCB) layer 215, the FPCB layer may include a first portion 40a and a second portion 40b separated from the first portion, and the second portion 40b may include a conductive member formed in a portion of an edge of the FPCB layer. The electronic device may further include a printed circuit board 260 disposed between the second surface of the outer housing and the display device, a feeding line 44 connecting a communication circuit on the printed circuit board to the outer housing so as to feed power to the outer housing, and a grounding line 41 connecting the conductive member to the printed circuit board. In addition, the grounding line may be included in a connector 43 that connects the printed circuit board to the display device.

According to an embodiment, the conductive member included in the second portion is electrically separated from the first portion, and the conductive member included in the second portion and the first portion may be coupled to each other.

According to an embodiment, as an RF signal is transmitted from the communication circuit to the outer housing, a capacitance may be formed between the conductive member included in the second portion and the first portion of the display device.

According to an embodiment, the connector may include a data line 42 configured to transmit an image signal provided from the printed circuit board to the display device 210.

According to an embodiment, the grounding line 41 may be connected to a switch 70 in the printed circuit board.

According to an embodiment, the electronic device may further include a communication processor 1812 or 1814, and the communication processor may be configured to control the switch so as to adjust an electrical length of an antenna radiator configured to radiate an RF signal provided from the communication circuit to the outer housing.

According to an embodiment, the switch may be connected to a matching circuit 72 including at least one lumped element.

According to an embodiment, the conductive member included in the second portion may be formed to have a length of about 10 mm or more and a width of about 1 mm or more.

According to an embodiment, the outer housing may include a conductive structure forming at least a portion of the first surface and/or the side surface of the outer housing and electrically connected to the communication circuit, and the feeding line may connect the communication circuit on the printed circuit board to the conductive structure included in the outer housing.

An electronic device according to an embodiment may include an outer housing 220 including a conductive structure formed in a region including a side surface of the electronic device, a display device 210 which is exposed, at least in part, through a first surface of the outer housing. The display device may include a flexible printed circuit board (FPCB) layer 215, the FPCB layer may include a first portion 40a and a second portion 40b separated from the first portion, and the second portion may be formed in a portion of an edge of the FPCB layer and include a conductive member 40. The electronic device may further include a printed circuit board 260 disposed between a second surface of the outer housing opposite to the first surface and the display device, and a grounding line 41 connecting the conductive member to the printed circuit board. In addition, the grounding line may be included in a connector 43 that connects the printed circuit board to the display device.

According to an embodiment, the conductive member included in the second portion separated from the first portion may be electrically separated from the first portion, and the conductive member included in the second portion and the first portion may be coupled to each other.

According to an embodiment, as an RF signal is transmitted from a communication circuit on the printed circuit board to the outer housing, a capacitance may be formed between the first portion and the second portion of the display device.

According to an embodiment, the connector may include a data line 42 configured to transmit an image signal provided from the printed circuit board to the display device.

According to an embodiment, the grounding line may be connected to a switch 70 in the printed circuit board, and the electronic device may further include a communication processor 1812 or 1814. The communication processor may be configured to control the switch so as to adjust an electrical length of an antenna radiator configured to radiate an RF signal provided from the communication circuit on the printed circuit board to the outer housing.

According to an embodiment, the outer housing may further include a conductive structure forming at least a portion of the first surface and/or the side surface of the outer housing and electrically connected to the communication circuit on the printed circuit board, and a feeding line configured to connect the communication circuit on the printed circuit board to the conductive structure included in the outer housing.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
an outer housing (220) including a first surface oriented in a first direction, a second surface oriented in a second direction opposite to the first direction, and a side surface surrounding a space between the first surface and the second surface;
a display device (210) which is exposed, at least in part, through the first surface of the outer housing, the display device including a plurality of layers including an FPCB (flexible printed circuit board) layer (215), the FPCB layer including a first portion (40a) and a second portion (40b) separated from the first portion, and the second portion including a conductive member formed in a portion of an edge of the FPCB layer;
a printed circuit board (260) disposed between the second surface of the outer housing and the display device;
a feeding line (44) connecting a communication circuit on the printed circuit board to the outer housing so as to feed power to the outer housing; and
a grounding line (41) connecting the conductive member to the printed circuit board,
wherein the grounding line is included in a connector (43) that connects the printed circuit board to the display device.

2. The electronic device of claim 1, wherein the conductive member included in the second portion separated from the first portion is electrically separated from the first portion, and the conductive member included in the second portion and the first portion are coupled to each other.

3. The electronic device of claim 1, wherein as an RF signal is transmitted from the communication circuit to the outer housing, a capacitance is formed between the first portion and the second portion of the display device.

4. The electronic device of claim 1, wherein the connector includes a data line (42) configured to transmit an image signal provided from the printed circuit board to the display device.

5. The electronic device of claim 1, wherein the grounding line is connected to a switch (70) in the printed circuit board.

6. The electronic device of claim 5, further comprising:
a communication processor (1812, 1814),
wherein the communication processor is configured to control the switch so as to adjust an electrical length of an antenna radiator configured to radiate an RF signal provided from the communication circuit to the outer housing.

7. The electronic device of claim 5, wherein the switch is connected to a matching circuit (72) including at least one lumped element.

8. The electronic device of claim 1, wherein the conductive member included in the second portion is formed to have a length of about 10 mm or more and a width of about 1 mm or more.

9. The electronic device of claim 1, wherein the outer housing forms at least a portion of the first surface and/or the side surface of the outer housing and includes a conductive structure electrically connected to the communication circuit, and
wherein the feeding line connects the communication circuit on the printed circuit board to the conductive structure included in the outer housing.

10. An electronic device comprising:
an outer housing (220) comprising a conductive structure formed in a region including a side surface of the electronic device;
a display device (210) which is exposed, at least in part, through a first surface of the outer housing, the display device including a flexible printed circuit board (FPCB) layer (215), the FPCB layer including a first portion (40a) and a second portion (40b) separated from the first portion, and the second portion being formed in a portion of an edge of the FPCB layer and including a conductive member (40);
a printed circuit board (260) disposed between a second surface of the outer housing opposite to the first surface and the display device; and
a grounding line (41) connecting the conductive member to the printed circuit board,
wherein the grounding line is included in a connector (43) that connects the printed circuit board to the display device.

11. The electronic device of claim 10, wherein the conductive member included in the second portion separated from the first portion is electrically separated from the first portion, and the conductive member included in the second portion and the first portion are coupled to each other.

12. The electronic device of claim 10, wherein as an RF signal is transmitted from a communication circuit on the printed circuit board to the outer housing, a capacitance is formed between the first portion and the second portion of the display device.

13. The electronic device of claim 10, wherein the connector includes a data line (42) configured to transmit an image signal provided from the printed circuit board to the display device.

14. The electronic device of claim 10, wherein the grounding line is connected to a switch (70) in the printed circuit board,
wherein the electronic device further comprises a communication processor (1812, 1814), and
wherein the communication processor is configured to control the switch so as to adjust an electrical length of an antenna radiator configured to radiate an RF signal provided from the communication circuit on the printed circuit board to the outer housing.

15. The electronic device of claim 10, wherein the outer housing further comprises:
a conductive structure forming at least a portion of the first surface and/or the side surface of the outer housing and electrically connected to the communication circuit on the printed circuit board; and
a feeding line connecting the communication circuit on the printed circuit board to the conductive structure included in the outer housing.
